# EUROPÄISCHE PATENTSCHRIFT

(11) **EP 3 206 464 B1**
(45) Veröffentlichungstag und Bekanntmachung des Hinweises auf die Patenterteilung: **11.10.2023**
(21) Anmeldenummer: 17155567.5
(22) Anmeldetag: 10.02.2017
(51) Int. Cl.: H05K 1/02, H05K 3/34, H05K 3/00, G02B 19/00, G02B 3/08, F21S 41/147, F21S 41/151, F21S 41/153, F21S 41/19, F21S 41/29, F21S 41/33, F21S 41/663

(54) **VERFAHREN ZUM HERSTELLEN EINES LICHTMODULS EINER KRAFTFAHRZEUGBELEUCHTUNGSEINRICHTUNG**
METHOD FOR PRODUCING A LIGHT MODULE OF A MOTOR VEHICLE LIGHTING DEVICE
PROCÉDÉ DE FABRICATION D'UN MODULE LUMINEUX D'UN DISPOSITIF D'ÉCLAIRAGE DE VÉHICULE AUTOMOBILE

(30) Priorität: 15.02.2016 DE 102016102637
(43) Veröffentlichungstag der Anmeldung: 16.08.2017
(73) Patentinhaber: Marelli Automotive Lighting Reutlingen (Germany) GmbH, 72762 Reutlingen (DE)
(72) Erfinder: Harder, Anna, 72768 Reutlingen (DE); Hiegler, Michael, 72760 Reutlingen (DE); Wilbert, Rolf, 72810 Gomaringen (DE)
(74) Vertreter: DREISS Patentanwälte PartG mbB

(56) Entgegenhaltungen:
- EP-A1- 2 722 900
- WO-A1-2015/000894
- DE-A1- 4 306 998
- DE-A1-102005 033 709
- US-A1- 2015 228 549
- Anonymous: "Passermarke - Wikipedia", , 26. Februar 2015 (2015-02-26), XP055388303, Gefunden im Internet: URL:https://de.wikipedia.org/w/index.php?t itle=Passermarke&oldid=139233642 [gefunden am 2017-07-05]

## Beschreibung

Die Erfindung betrifft ein Verfahren zum Herstellen eines Lichtmoduls einer Kraftfahrzeugbeleuchtungseinrichtung nach dem Oberbegriff des Anspruchs 1 sowie ein Lichtmodul einer Kraftfahrzeugbeleuchtungseinrichtung nach dem Oberbegriff eines nebengeordneten Anspruchs.

Es ist bekannt, dass im Bereich der SMT-Fertigung, Surface Mounted Technology, zu einem Bestücken einer Leiterplatte Passermarken verwendet werden, die im Leiterbild der Leiterplatte enthalten sind. Hierzu wird mittels automatischer optischer Inspektion, AOI, eine Position der Passermarke bzw. des Leiterbildes ermittelt, um daraus die Position zum Bedrucken mit Lötpaste bzw. die Bestückungsposition für einzelne Bauelemente zu ermitteln.

Des Weiteren ist bekannt, dass bei der Leiterplattenfertigung sich ein Versatz zwischen einem Leiterbild und einem Bohrbild ergeben kann, da diese in verschiedenen Prozessschritten hergestellt werden.

Allerdings werden Halbleiterlichtquellenbauelemente anhand des Leiterbilds bestückt, wohingegen optische Komponenten wie beispielsweise Reflektoren mechanisch direkt oder indirekt mittels in eine Leiterplatte gebohrter Löcher auf einer Leiterplatte ausgerichtet bzw. befestigt werden. Stimmen die Positionen der Leiterbahnen und ein Bohrbild der Leiterplatte jedoch nicht überein, so wird das Halbleiterlichtquellenbauelement nicht in der Position mit der Leiterplatte verbunden, welche zur exakten Ausrichtung von Halbleiterlichtquelle und Reflektor nötig ist.

Des Weiteren ist bekannt, dass im Bereich der Kraftfahrzeugbeleuchtungseinrichtungen hohe Toleranzanforderungen erfüllt werden müssen, um eine gewünschte Lichtverteilung auf einer Straße vor dem Kraftfahrzeug zu erzeugen. Sind nun das Halbleiterlichtquellenbauelement und der Reflektor nicht exakt zueinander ausgerichtet, so hat dies negative Auswirkungen auf die gewünschte Lichtverteilung.

WO2015000894A1 offenbart ein Verfahren zur Bestückung elektronischer Leiterplatten mit optischen Bauelementen, wobei die optischen Bauelemente mittels Bildverarbeitungssystemen vermessen und positioniert werden, mit folgenden Verfahrens- schritten: - die optischen Bauelemente werden vor dem eigentlichen Bestückungsvorgang, vorzugsweise im Zuführgurt vermessen und die Position der optisch maßgeblichen Elemente in Bezug zum Gesamtbauelement ermittelt und daraus ein erster Korrekturfaktor berechnet, - aus in der Leiterplatte vorhandenen Referenzpunkten für weitere optische Bauelemente wird zumindest ein weiterer Korrekturfaktor berechnet, - beim Bestückungsvorgang werden die vorgegebenen Einbaupositionen mit den Korrekturfaktoren korrigiert und eine tatsächliche Einbauposition ermittelt, - die optischen Bauelemente werden an der tatsächlichen Einbauposition aufgesetzt. Damit ist eine präzise Positionierung der optischen Bauelemente zueinander möglich.

DE4306998A1 offenbart, dass eine Referenzmarkierung auf einer gedruckten Schaltkreisplatine in ihrem Bild erkannt wird, um Punkte zu bestimmen, um dadurch den vorläufigen Mittelpunkt und Durchmesser der Markierung durch ein Vier-Punkt-Suchverfahren zu bestimmen.

EP2722900A1 offenbart eine Lichtquellen-Schaltungseinheit, die die Effizienz der Lichtextraktion verbessert, sowie eine Beleuchtungseinrichtung und eine Anzeige, die eine solche Lichtquellen-Schaltungseinheit enthalten. Die Lichtquellenschaltungseinheit umfasst: ein Schaltungssubstrat mit einem Verdrahtungsmuster auf einer Oberfläche davon, wobei das Verdrahtungsmuster Lichtreflexionsvermögen aufweist, einen kreisförmigen Sockel, der auf dem Schaltungssubstrat vorgesehen ist, einen wasserabweisenden Bereich, der zumindest von einem Umfangskantenabschnitt des Sockels zu einem Teil einer Seitenfläche des Sockels vorgesehen ist, und einen oder zwei oder mehr lichtemittierende Vorrichtungschips, die auf dem Sockel montiert sind und durch einen Strom angetrieben werden, der durch das Verdrahtungsmuster fließt.

US2015228549A1 offenbart ein Verfahren zum Aufbau eines LED-Lichtmoduls, mit einer Leiterplatte, auf der mindestens eine LED-Lampe untergebracht ist, und mit mindestens einem optischen Element, in das das von der LED-Lampe erzeugte Licht abgestrahlt werden kann, wobei das optische Element Befestigungsstifte aufweist und wobei in der Leiterplatte Löcher gebildet werden, so dass das optische Element durch ein Einsetzen der Befestigungsstifte in die Löcher auf der Leiterplatte angeordnet wird, wobei das Verfahren mindestens die folgenden Schritte umfasst: Anordnen mindestens einer LED-Lampe auf einer Montagefläche der Leiterplatte, Messen der Position der LED-Lampe in der Ebene der Montagefläche der Leiterplatte, Erzeugen der Löcher in der Leiterplatte an einer Position, die von der gemessenen Position der LED-Lampe in der Ebene der Montagefläche abhängig ist, und Anordnen des optischen Elements auf der Leiterplatte durch ein Einsetzen der Montagestifte in die Löcher.

DE102005033709A1 offenbart ein Licht emittierendes Modul mit einer Lichtquelle, einem Träger für die Lichtquelle und einem optischen Element, wobei das optische Element Passstifte aufweist, die in korrespondierende Ausnehmung des Trägers eingreifen. Das Licht emittierende Modul eignet sich besonders gut für die Verwendung in optischen Projektionsgeräten sowie in Kfz-Scheinwerfern. Aufgabe der Erfindung ist es somit, die Genauigkeit der lichttechnischen Abbildung einer Kraftfahrzeugbeleuchtungseinrichtung zu erhöhen.

Die der Erfindung zugrunde liegende Aufgabe wird durch ein Verfahren nach dem Anspruch 1 gelöst. Für die Erfindung wichtige Merkmale finden sich ferner in der nachfolgenden Beschreibung und in den Zeichnungen, wobei die Merkmale sowohl in Alleinstellung als auch in unterschiedlichen Kombinationen für die Erfindung wichtig sein können, ohne dass hierauf nochmals explizit hingewiesen wird.

Dadurch, dass einer Passermarke eine jeweilige Referenzbohrung durch die Leiterplatte zugeordnet ist, dass eine erste Position der zugeordneten Passermarke von einer zweiten Position der Referenzbohrung abweicht, und dass ein lichtemittierendes Bauelement um die Abweichung zwischen der ersten und zweiten Position verlagert auf der Leiterplatte angeordnet ist, wird vorteilhaft auf einfache Art und Weise die Fertigungsqualität verbessert und eine optische Abbildung des von lichtemittierenden Bauelementen ausgehenden Lichtes wird vorteilhaft verbessert. Insbesondere ist somit die Abweichung des Bohrbildes von dem Leiterbild der Leiterplatte dauerhaft, nachvollziehbar und prozesskompatibel festgehalten.

In Abhängigkeit von der ersten Position und in Abhängigkeit von der zweiten Position wird ein Versatz und/oder eine Verdrehung zwischen einem Leiterbild und einem Bohrbild der Leiterplatte ermittelt. Die optische Komponente wird in Abhängigkeit von dem Versatz und/oder der Verdrehung auf der Leiterplatte angeordnet. Durch die Ermittlung des Versatzes kann vorteilhaft ermittelt werden, ob die Leiterplatte einem zuvor festgelegten Toleranzprofil entspricht.

Bei der Leiterplattenfertigung werden die Referenzbohrung und eine Befestigungsbohrung zur Verbindung der Leiterplatte mit der optischen Komponente mittels desselben Bohrprogramms ausgeführt. Durch die Verwendung desselben Bohrprogramms können vorteilhaft Toleranzunterschiede zwischen verschiedenen Bohrschritten verhindert werden und der Versatz des Bohrbildes ist für alle weiteren Prozessschritte durch die Referenzbohrung verwendbar.

Die Referenzbohrung ist im Bereich der Passermarke angeordnet, was vorteilhaft die Erkennung des Versatzes zwischen Bohrbild und Leiterbild durch AOI ermöglicht.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Für funktionsäquivalente Größen und Merkmale werden in allen Figuren auch bei unterschiedlichen Ausführungsformen und illustrativen, nicht zur Erfindung gehörenden Beispielen die gleichen Bezugszeichen verwendet.

Nachfolgend werden beispielhafte Ausführungsformen der Erfindung und illustrative, nicht zur Erfindung gehörende Beispiele unter Bezugnahme auf die Zeichnung erläutert. In der Zeichnung zeigen:
- Figur 1: ein Lichtmodul in schematischer perspektivischer Darstellung;
- Figur 2: eine schematische Draufsicht auf eine Leiterplatte des Lichtmoduls;
- Figur 3: zeigt einen Teil des Lichtmoduls in einer perspektivischen Explosionsansicht;
- Figuren 4 und 6: jeweils eine Draufsicht auf eine Leiterplatte des Lichtmoduls; und
- Figuren 5 und 7: jeweils ein schematisches Ablaufdiagramm.

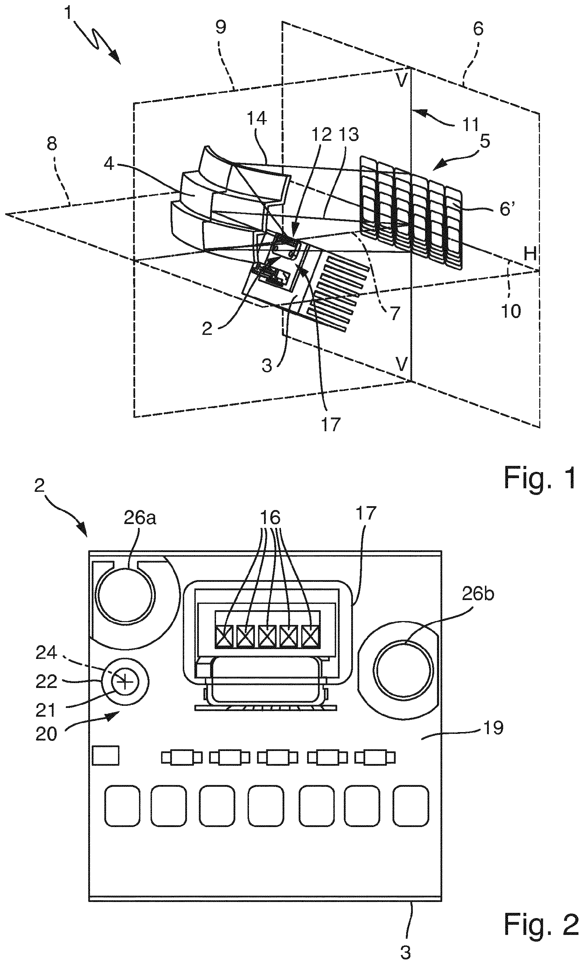

Figur 1 zeigt ein Lichtmodul 1 mit mehreren Halbleiterlichtquellen zum Aussenden von Licht, die entsprechend einer Lichtquellenanordnung 2 zusammengefasst sind. Selbstverständlich kann auch nur eine Halbleiterlichtquelle vorhanden sein. Die Lichtquellenanordnung 2 ist auf einem Kühlkörper 3 angeordnet, wobei auch Ausführungsformen ohne den Kühlkörper 3 denkbar sind. Selbstverständlich können auch mehrere Halbleiterlichtquellen in Reihe übereinander matrixartig angeordnet sein. Zum Bündeln von zumindest einem Teil des von den Halbleiterlichtquellen ausgesandten Lichts und zum Erzeugen einer Zwischenlichtverteilung ist den Halbleiterlichtquellen ein Primäroptikelement 17 zugeordnet.

Das Primäroptikelement 17 umfasst beispielsweise mehrere Primäroptikelemente für je eine Halbleiterlichtquelle. Das Primäroptikelement 17 ist auch als Vorsatzoptik oder als optische Komponente bezeichenbar. Die Zwischenlichtverteilungen werden auf Lichtaustrittsflächen des Primäroptikelements 17 erzeugt. Die Zwischenlichtverteilungen werden von einem Sekundäroptiksystem 4 auf einer Fahrbahn vor einem Kraftfahrzeug als Einzellichtverteilungen 6' zur Erzeugung einer resultierenden Gesamtlichtverteilung 5 des Lichtmoduls 1 abgebildet. Das Sekundäroptiksystem 4 ist in dem dargestellten Beispiel als ein horizontal facettierter Reflektor, insbesondere Parabelreflektor, ausgebildet. Des Weiteren ist eine optische Achse 7 des Lichtmoduls 1 gezeigt. Eine Sagittalebene 8 hat eine im Wesentlichen horizontale Flächenerstreckung und umfasst die optische Achse 7. Eine Meridionalebene 9 hat eine im Wesentlichen vertikale Erstreckung und umfasst ebenfalls die optische Achse 7. Eine Schnittlinie zwischen der Sagittalebene 8 und dem Messschirm 6 bildet eine Horizontale HH 10 und eine Schnittlinie zwischen der Meridionalebene 9 und dem Messschirm 6 bildet eine Vertikale W 11. Die optische Achse 7 verläuft durch den Schnittpunkt HV der Horizontalen 10 und der Vertikalen 11. Die resultierende Gesamtlichtverteilung 5 erstreckt sich sowohl unterhalb der Horizontalen 10 als auch oberhalb der Horizontalen 10. Bei der Gesamtlichtverteilung 5 kann es sich beispielsweise um ein sogenanntes Matrix-Fernlicht bzw. um ein sogenanntes Streifen-Fernlicht oder um einen Teil davon handeln. Die Gesamtlichtverteilung 5 kann aber auch einen besonders hell ausgeleuchteten zentralen Bereich des Fernlichts, einen sogenannten Fernlichtspot, bilden.

Ein Brennpunkt des facettierten Parabelreflektors 4 ist mit dem Bezugszeichen 12 bezeichnet. Ein Strahlengang eines Hauptstrahls ist mit dem Bezugszeichen 13 und der Strahlengang eines Nebenstrahls mit dem Bezugszeichen 14 bezeichnet. Der Hauptstrahl 13 ergibt sich aus einem im Wesentlichen in Hauptabstrahlrichtung einer der Lichtquellen ausgesandten Lichtstrahl, durch Formung und evtl. Umlenkung durch das der Lichtquelle zugeordnete Primäroptikelement 17 sowie durch Umlenkung an dem Sekundäroptiksystem 4. Der Nebenstrahl 14 ergibt sich dementsprechend durch einen schräg zur Hauptabstrahlrichtung ausgesandten Lichtstrahl.

Figur 2 zeigt eine Draufsicht auf die Lichtquellenanordnung 2, die mehrere lichtemittierende Bauelemente 16, insbesondere Halbleiterlichtquellen, umfasst. Die lichtemittierenden Bauelemente 16 sind auf einer Leiterplatte 19 angeordnet. Insbesondere sind lichtemittierende Bauelemente 16 als SMD-LEDs (Surface Mounted Device-Light Emitting Diode) ausgebildet. Die Leiterplatte 2 ist auf dem Kühlkörper 3 angeordnet. Das Primäroptikelement 17 ist über den lichtemittierenden Bauelementen 16 angeordnet. Das Primäroptikelement 17 ist auch als optisches Element bezeichenbar, das optisch mit den lichtemittierenden Bauelementen 16 zusammenwirkt. In einem nicht zur Erfindung gehörenden, illustrativen Beispiel des Lichtmoduls 1 kann anstatt eines Primäroptikelements 17 auch ein Reflektor mit der Leiterplatte 19 verbunden sein, der auch als optische Komponente bezeichnet wird.

Die Leiterplatte 19 umfasst eine Passermarke 20, die sich vorliegend aus zwei konzentrischen Kreisen 21 und 22 zusammensetzt. Die beiden konzentrischen Kreise 21 und 22, welche im Kupferbild der Leiterplatte 19 ausgebildet sind, haben einen gemeinsamen Kreismittelpunkt, der als erste Position 24 bezeichnet wird. Zur Verbesserung der Genauigkeit können selbstverständlich auch weitere Passermarken 20 auf der Leiterplatte 19 angeordnet sein. Die Passermarke 20 kann selbstverständlich auch ein anderes Aussehen in Form anderer Geometrien aufweisen. Des Weiteren sind in Figur 2 zwei Durchgangsbohrungen 26a und 26b beispielsweise zur Befestigung des Kühlkörpers 3 gezeigt.

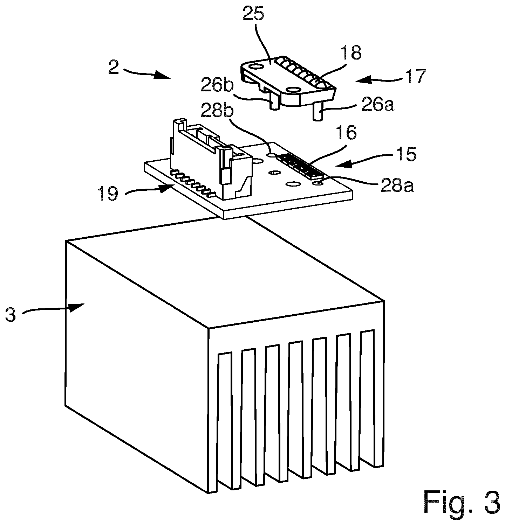

Figur 3 zeigt eine Explosionsansicht der in Figur 2 gezeigten Draufsicht. Das Primäroptikelement 17 weist Sammellinsen 18 auf, die entsprechende Lichtaustrittsflächen 25 umfassen. Des Weiteren weist das Primäroptikelement 17 Vorsprünge 26 auf, die zum Eingriff in Bohrungen 28 vorgesehen sind. Selbstverständlich kann anstatt der Vorsprünge 26 auch ein anderes Befestigungs- bzw. Verbindungsmittel zur Verbindung des Primäroptikelements 17 und der Leiterplatte 19 gewählt werden.

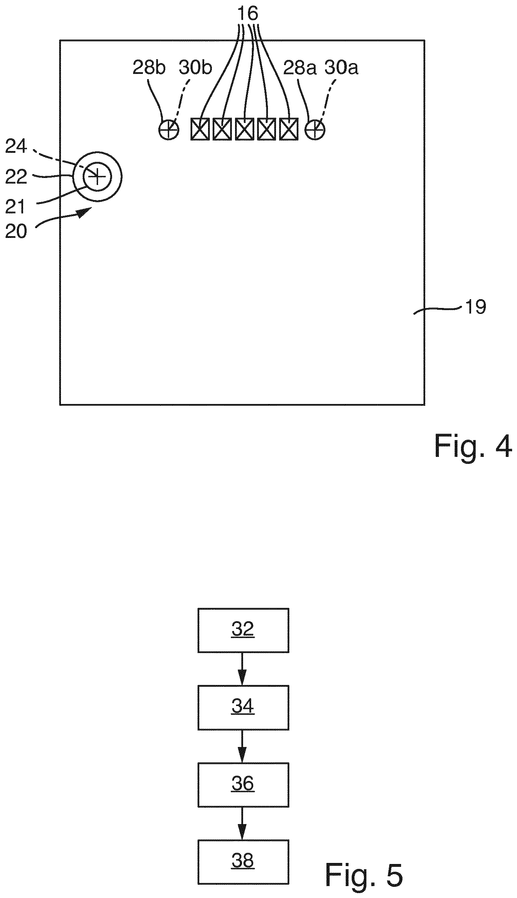

Figur 4 zeigt in schematischer Form die Draufsicht auf eine Leiterplatte 19 gemäß eines nicht zur Erfindung gehörenden Verfahrens.

Die Bohrungen 28 sind jeweils an einer zweiten Position 30 ausgeführt. Wie bereits vorher erwähnt, können durch die Bohrungen 28, die jeweils als Referenzbohrung bezeichenbar sind, Passstifte oder Steckpins eingeschossen werden, die wiederum zum Eingriff in entsprechende Bohrungen in dem Primäroptikelement 17 eingreifen. Der Steckpin ist besonders gut geeignet, um bei einem automatischen Bestückungsprozess verwendet zu werden. Selbstverständlich können auch mehrere Bohrungen 28 vorgesehen werden. Die Bohrung 28 ist auch als Befestigungsbohrung bezeichenbar. Selbstverständlich können auch mehr als die eine gezeigte Passermarke 20 auf der Leiterplatte 19 angeordnet sein. Bevorzugt sind zwei oder drei Passermarken 20 auf der Leiterplatte 19 angeordnet.

Figur 5 zeigt ein schematisches Ablaufdiagramm zur Anordnung der optischen Komponente 17 auf der Leiterplatte 19 der Figur 4 gemäß des nicht zur Erfindung gehörenden Verfahrens. In einem ersten Schritt 32 wird die Leiterplatte 19 gefertigt. Der Leiterplattenfertigung immanent ist ein möglicher Versatz zwischen einem Leiterbild und einem Bohrbild, weshalb die Bohrung 28 erst nach Abschluss der Leiterplattenfertigung in einem Schritt 36 durchgeführt wird. In einem auf die Leiterplattenfertigung 32 folgenden zweiten Schritt 34 wird die zweite Position 30 in Abhängigkeit von der ersten Position 24 ermittelt. In dem auf den zweiten Schritt 34 folgenden dritten Schritt 36 wird die Bohrung 28 durch die Leiterplatte 19 durchgeführt. In einem auf den dritten Schritt 36 folgenden vierten Schritt 38 wird die optische Komponente 17 zu der Leiterplatte 19 festgelegt, wobei neben einem Passstift oder einem Steckpin beispielsweise auch weitere Befestigungsmittel, insbesondere eine Schraube, zur zusätzlichen Verbindung zwischen der optischen Komponente 17 und der Leiterplatte 19 Verwendung finden können. Eine Bestückung der Leiterplatte 19 mit den lichtemittierenden Bauelementen 16 kann zwischen den Schritten 32 und 34 und den Schritten 36 und 38 erfolgen. Der mögliche Versatz zwischen Bohrbild und Kupferbild der Leiterplatte 19 wird durch die Anordnung der Bohrung 28 in Abhängigkeit von der Position 24 also in Abhängigkeit von dem Kupferbild kompensiert.

Damit wird gemäß den Verfahrensschritten der Figur 5 die optische Komponente 17 beispielsweise aus einer der Figuren 2 und 3 in Abhängigkeit von der ersten Position 24 zumindest einer Passermarke und in Abhängigkeit von einer zweiten Position 30 zumindest einer Bohrung 28 durch die Leiterplatte 19 mit der Leiterplatte 19 verbunden. Die Anordnung des lichtemittierenden Bauelements 16 und das Bohren der Bohrung 28 durch die Leiterplatte 19 werden jeweils in Abhängigkeit von der Passermarke 20 ausgeführt. Das Primäroptikelement 17 wird mittels der Bohrung 28 und eines darin angeordneten Befestigungselements wie beispielsweise eines Passstifts oder eines Steckpins zu der Leiterplatte 19 festgelegt.

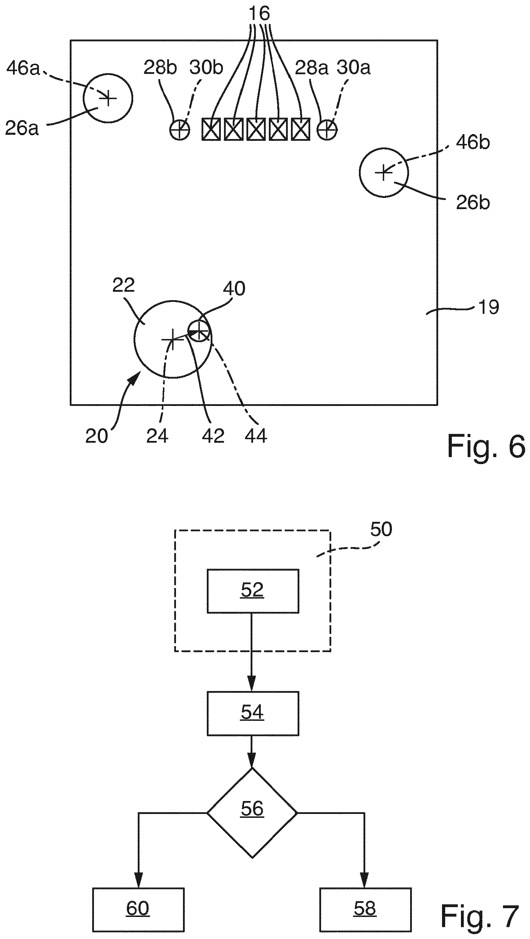

Figur 6 zeigt eine schematische Draufsicht auf die Leiterplatte 19 gemäß eines Ausführungsbeispiels des erfindungsgemäßen Verfahrens. Im Unterschied zu dem nicht zur Erfindung gehörenden Beispiel gemäß den Figuren 4 und 5 werden nicht die Bohrungen 28 als Referenzbohrung bezeichnet, sondern es wird eine weitere Bohrung 40 als Referenzbohrung bezeichnet. Die Referenzbohrung 40 wird während der Leiterplattenfertigung gemeinsam mit den Bohrungen 26 und 28 mittels eines einzigen Bohrprogramms durchgeführt. Die Leiterplatte 19 gemäß Figur 6 zeigt des Weiteren die Passermarke 20 mit der ersten Position 24. Die Passermarke 20 weist vorliegend nur einen Kreis 22 auf und ist gemeinsam mit der Referenzbohrung 40 aus zeichnerischen Gründen übertrieben groß dargestellt. Bevorzugt sind zwei oder drei Passermarken 20 auf der Leiterplatte 19 angeordnet.

Das Bohrprogramm zur Anordnung der Referenzbohrung 40 wird so programmiert, dass als Ziel-Koordinate die erste Position 24 für die Referenzbohrung 40 verwendet wird. Ist ein Unterschied zwischen den durch das Bohrprogramm durchgeführten Bohrungen 26, 28 und 40 und dem Leiterbild vorhanden, so zeigt sich ein Versatz 42 zwischen der ersten Position 24 der Passermarke 20 und der Position 44 der Referenzbohrung 40, wobei die Position 44 auch als zweite Position in diesem Zusammenhang bezeichnet wird. Der Versatz 42 und damit die Positionen 24 und 44 sind lediglich beispielhaft dargestellt. Bei einem Übereinstimmen der Positionen zwischen dem Leiterbild und dem Bohrbild befindet sich die zweite Position 44 exakt über der ersten Position 24.

Die Bohrungen 28 sind gegenüber dem Kupferbild um den Versatz 42 verschoben. Dementsprechend werden die lichtemittierenden Bauelemente 16 beim Bestücken um den Versatz 42 gegenüber der Sollposition platziert. Dabei sind die Lötpads für die Bauelemente 16 entsprechend größer, damit bei einem Versatz die Kontaktierung sichergestellt ist. Positionen 46 der Bohrungen 26 sind durch das Bohrprogramm, mit dem auch die Bohrungen 28 und 40 durchgeführt werden, durch den Versatz 42 gekennzeichnet und sind Teil des Bohrbildes.

In nicht gezeigter Form sind auf der Leiterplatte 19 mehrere Passermarken 20, insbesondere mindestens drei Passermarken 20, angeordnet, wobei in zumindest einer der Passermarken 20 eine Referenzbohrung 40 ausgeführt wird. Mit der Anzahl der Passermarken 20 und den jeweiligen Referenzbohrungen 40 lässt sich der Versatz 42 genauer ermitteln, wobei neben dem Versatz auch eine Verdrehung des Bohrbildes gegenüber dem Leiterbild erkannt werden kann.

Als Passermarken 20 sind eine Vielzahl von Geometrien der Kupferlage geeignet, welche sicher mit einem optischen Inspektionssystem erkannt werden. Die in den Figuren 5 und 6 gezeigten Passermarken 20 können somit auch anders ausgeführt sein und beispielsweise andere geometrische Formen wie Kreuze, Kreise oder ähnliches enthalten. Die Passermarken 20 sollten während der Leiterplattenfertigung nicht mit Lötpaste oder Lötstopplack überdeckt werden.

Eine vorteilhafte Geometrie für die Passermarke 20 ist ein einziger Ring in der Kupferlage der Leiterplatte 19, in dessen Zentrum im Wesentlichen keine weiteren Kupferstrukturen liegen. Die Durchgangsbohrung 40 wird bevorzugt innerhalb dieser ringförmigen Struktur der Passermarke 20 erzeugt.

Figur 7 zeigt ein schematisches Ablaufdiagramm zur Herstellung einer Leiterplatte 19 eines Lichtmoduls 1 gemäß der Ausführungsform der Figur 6. Während einer Leiterplattenfertigung 50 wird in einem ersten Schritt 52 die Referenzbohrung 40 und eine Befestigungsbohrung 28 zur Verbindung der Leiterplatte 19 mit der optischen Komponente 17 mittels desselben Bohrprogramms ausgeführt, womit die Bohrung der Referenzmarke 40 im gleichen Schritt erzeugt wird wie die Bohrungen zur Befestigung der optischen Komponente 17.

Zur Anordnung der optischen Komponente 17 wird in einem zweiten Schritt 54 der Versatz 42 ermittelt. Überschreitet der Versatz 42 und/oder die Verdrehung gemäß einer Verzeigung 56 einen Schwellwert, so wird in einem dritten Schritt 58 die entsprechende Leiterplatte 19 aussortiert. In einer alternativen Ausführungsform kann der dritte Schritt 58 eine Justage der optischen Komponente 17 mittels der Bohrungen 28 und mittels durch die Bohrungen 28 geführter Pins umfassen.

Ist der Versatz 42 und/oder die Verdrehung hingegen tolerierbar, das bedeutet, unterschreitet der Versatz 42 und/oder die Verdrehung den Schwellwert, so wird ein vierter Schritt 60 ausgeführt und im vierten Schritt 60 wird die Leiterplatte 19 weiterverarbeitet, beispielsweise wird die optische Komponente 17 über die Bohrungen 28 mit der Leiterplatte 19 verbunden. Des Weiteren findet in dem vierten Schritt eine Bestückung der Leiterplatte 40 in Abhängigkeit von der Referenzbohrung 40, also in Abhängigkeit von dem Versatz 42 und/oder der Verdrehung, statt. Insbesondere werden die lichtemittierenden Bauelemente 16 in Abhängigkeit von der Referenzbohrung 40 auf der Leiterplatte 19 angeordnet.

Mithin wird die optische Komponente 17 in Abhängigkeit von der ersten Position 24 der zumindest einen Passermarke 20 und in Abhängigkeit von der zweiten Position 44 zumindest einer Referenzbohrung 40 durch die Leiterplatte 19 mit der Leiterplatte 19 verbunden.

Der Passermarke 20 ist somit die jeweilige Referenzbohrung 40 durch die Leiterplatte 19 zugeordnet, was bedeutet, dass die Referenzbohrung 40 innerhalb der Passermarke 20 angeordnet ist. Die erste Position 24 der zugeordneten Passermarke 20 weicht von der zweiten Position 44 der Referenzbohrung 40 ab. Das lichtemittierende Bauelement 16 wird um die Abweichung 42 zwischen der ersten und zweiten Position 24, 44 verlagert auf der Leiterplatte 19 angeordnet. Nach der Bestückung der Leiterplatte 19 mit elektronischen Bauteilen umfassend die lichtemittierenden Bauelemente 16 werden weitere mechanische Elemente wie beispielsweise die optische Komponente 17 mit der Leiterplatte 19 verbunden.

## Patentansprüche

1. Ein Verfahren zum Herstellen einer Leiterplatte (19) für ein Lichtmodul (1) einer Kraftfahrzeugbeleuchtungseinrichtung, wobei eine Passermarke (20) im Leiterbild der Leiterplatte (19) vorgesehen wird, wobei in der Passermarke (20) eine Referenzbohrung (40) durch die Leiterplatte (19) ausgeführt wird, wobei die Referenzbohrung (40) und eine Befestigungsbohrung (28) zur Verbindung der Leiterplatte (19) mit einem Primäroptikelement (17) Teil eines Bohrbilds sind und mittels desselben Bohrprogramms ausgeführt werden, wobei eine Abweichung (42) zwischen Positionen (24, 44) der Passermarke (20) und der Referenzbohrung (40) einem Versatz der Positionen vom Leiterbild und vom Bohrbild entspricht, wobei ein lichtemittierendes Bauelement (16) um die Abweichung (42) verlagert auf der Leiterplatte (19) angeordnet wird, und wobei das Primäroptikelement (17) mittels der Befestigungsbohrung (28) zu der Leiterplatte (19) festgelegt wird.

## Claims

1. Method for producing a printed circuit board (19) for a light module (1) of a motor vehicle lighting device, wherein a fiducial marker (20) is provided in the conductive pattern of the printed circuit board (19), wherein a reference hole (40) through the printed circuit board (19) is formed in the fiducial marker (20), wherein the reference hole (40) and a fastening hole (28) for connecting the printed circuit board (19) to a primary optical element (17) are part of a hole pattern and are formed by means of the same drilling program, wherein a deviation (42) between positions (24, 44) of the fiducial marker (20) and the reference hole (40) corresponds to an offset of the positions of the conductive pattern and the hole pattern, wherein a light-emitting component (16) is arranged on the printed circuit board (19) so as to be displaced by the deviation (42), and wherein the primary optical element (17) is fixed to the printed circuit board (19) by means of the fastening hole (28).

## Revendications

1. Procédé de fabrication d'une carte de circuit imprimé (19) pour module d'éclairage (1) d'un dispositif d'éclairage de véhicule automobile, dans lequel une marque de repérage (20) est prévue dans le motif conducteur de la carte de circuit imprimé (19), dans lequel un alésage de référence (40) est exécuté dans la marque de repérage (20) à travers la carte de circuit imprimé (19), dans lequel l'alésage de référence (40) et un alésage de fixation (28) font partie d'un motif de perçage destiné à connecter la carte de circuit imprimé (19) avec un élément optique primaire (17) et sont exécutés au moyen du même programme de perçage, dans lequel un écart (42) entre des positions (24, 44) de la marque de repérage (20) et l'alésage de référence (40) correspond à un décalage des positions du motif conducteur et du motif de perçage, dans lequel un composant électroluminescent (16) est agencé sur la carte de circuit imprimé (19) en étant décalé de l'écart (42) et dans lequel l'élément optique primaire (17) est fixé à la carte de circuit imprimé (19) au moyen de l'alésage de fixation (28).
